# EUROPEAN PATENT SPECIFICATION

(11) **EP 3 742 875 B1**
(45) Date of publication and mention of the grant of the patent: **12.07.2023**
(21) Application number: 19175952.1
(22) Date of filing: 22.05.2019
(51) Int. Cl.: H05K 7/20

(54) **THERMAL MANAGEMENT IN AN ELECTRONIC DEVICE**
WÄRMEMANAGEMENT IN EINER ELEKTRONISCHEN VORRICHTUNG
GESTION THERMIQUE DANS UN DISPOSITIF ÉLECTRONIQUE

(43) Date of publication of application: 25.11.2020
(73) Proprietor: Veoneer Sweden AB, 447 83 Vårgårda (SE)
(72) Inventor: Persson, Madeleine, 483 30 Linköping (SE)
(74) Representative: Westpatent AB

(56) References cited:
- WO-A1-2014/021046
- US-A- 4 605 986
- US-A1- 2011 149 518
- US-A1- 2015 131 225

## Description

### DESCRIPTION OF THE DISCLOSURE

The present disclosure relates to an electronic device comprising an electronic component arrangement mounted to a printed circuit board, a thermally conducting housing that is attached to the PCB, and a thermally conducting foil element that is thermally connected to the housing.

Many vehicle environment detection systems comprise one or more sensors such as for example radar sensor, LIDAR sensors, camera devices and ultrasonic sensors. These are used for collecting data used for safety arrangements as well as for driver assistance systems.

Regarding camera devices, these comprise electronic circuitry such as electronic control units that radiate thermal energy in the form of heat that has to be dissipated. This is the case for many other types of electronic devices as well, and it is therefore desired to provide as efficient heat dissipation as possible.

Today, a component is placed on a PCB (Printed Circuit Board) and a heat spreader is assembled to the component. A relatively thin layer of thermal interface material (TIM) is placed between the die and the heat spreader within the component. A thicker layer of TIM is positioned between a metal housing and the heat spreader. This arrangement is somewhat sensitive to tolerances, and it is therefore desired to have an efficient heat dissipation where mounting tolerances of heat dissipation parts can be handled in a more efficient manner.

US 6351194 discloses a heat conducting foil that has one part that is brought into contact with a heat-generating component and another part that is brought into contact with a metal cover such that heat generated in the component is transferred to the metal cover via the heat conducting foil. Between the parts there is a slack.

US 4 605 986 discloses an electrical circuit component which, in operation, generates heat. Eyelet rivets extend through holes of a first heat transfer element or base plate, and are used to attach a spring to the holder and to the base plate. The eyelets are riveted in the back of the base plate. The spring is used to press electrical components against the base plate in order to insure good heat transition, with a foil sandwiched between the base plate and the components.

US 2015/131225 discloses a mobile terminal where a heat radiator is attached to a back panel. A back cover that is detachably connected to a main body has a perforated portion that is adapted to allow the heat from the mobile terminal to escape.

WO 2014/021046 discloses an electronic apparatus with a housing, a circuit board with an electronic component, and a heat conductive sheet. The heat conductive sheet is bonded to the electronic component as well as to the inner surface of the housing.

US 2011/149518 discloses an electronics module designed to efficiently remove heat from enclosed circuit boards via one or more configurable heat conduits, configured to provide good thermal contact between the corresponding heat-generating electronic device of an enclosed circuit board and a clamshell housing that encloses the circuit board.

It is, however, desired to obtain an efficient method for mounting an electronic device where a heat-generating component, such as a camera circuit, is conferred a suitable cooling. It is also desired to obtain an electronic device that enables such a mounting method.

It is an object of the present disclosure to provide such a method and such an electronic device.

Said object is achieved by means of an electronic device comprising an electronic component arrangement mounted to a printed circuit board (PCB), a thermally conducting housing that is attached to the PCB, and a thermally conducting foil element that is thermally connected to the housing. The housing comprises an opening enabling the foil element to be thermally connected also to the electronic component arrangement.

This enables an efficient mounting of an electronic device where a heat-generating component is conferred a suitable cooling.

According to some aspects, the opening is closed by a cover when the foil element has been thermally connected to the electronic component arrangement.

In this way, the opening in the electronic device is sealed.

According to some aspects, the cover is an electrically conducting adhesive film.

In this way, the opening in the electronic device is electrically sealed.

According to some aspects, the housing is either formed in metal or in a thermally conducting non-metallic material.

In this way, the housing can act as a heatsink.

According to some aspects, the foil element is formed in metal or in a thermally conducting graphite material with a protective coating.

The foil elements can thus be formed in many suitable materials.

According to some aspects, each thermal connection is made via a corresponding layer of thermal interface material (TIM).

In this way, an efficient thermal connection is obtained.

This object is also achieved by means of a method associated with the above advantages.

More in detail, the method is directed towards mounting an electronic device, and comprises mounting an electronic component arrangement to a printed circuit board (PCB), thermally connecting at least one first type part of a thermally conducting foil element to a thermally conducting housing and attaching the housing to the PCB. The method further comprises, via at least one corresponding opening in the housing, pressing at least one second type part of the foil element towards the electronic component arrangement such that the foil element becomes thermally connected to the electronic component arrangement.

### BRIEF DESCRIPTION OF THE DRAWINGS

The present disclosure will now be described more in detail with reference to the appended drawings, where:
- Figure 1: shows a schematic cut-open part of a vehicle with a camera device;
- Figure 2: shows a schematic side view of a component arrangement mounted to a PCB;
- Figure 3: shows a schematic side view of a component arrangement mounted to a PCB and having TIM applied;
- Figure 4: shows a schematic cut-open side view of an electronic unit before attaching foil element;
- Figure 5: shows a schematic cut-open side view of an electronic unit in a first step of attaching the foil element;
- Figure 6: shows a schematic cut-open side view of an electronic unit in a second step of attaching the foil element;
- Figure 7: shows a schematic cut-open side view of an electronic unit with attached foil element and sealed opening;
- Figure 8: shows a schematic cut-open side view of an electronic unit before attaching foil element with TIM for thermal contact the electronic component arrangement is applied to the foil element;
- Figure 9: shows a schematic cut-open side view of an electronic unit with attached foil element and sealed opening,, and with additional TIM;
- Figure 10: shows a flowchart for methods according to the present disclosure; and
- Figure: 11 shows a schematic cut-open side view of an alternative electronic unit with attached foil element and sealed opening.

### DETAILED DESCRIPTION

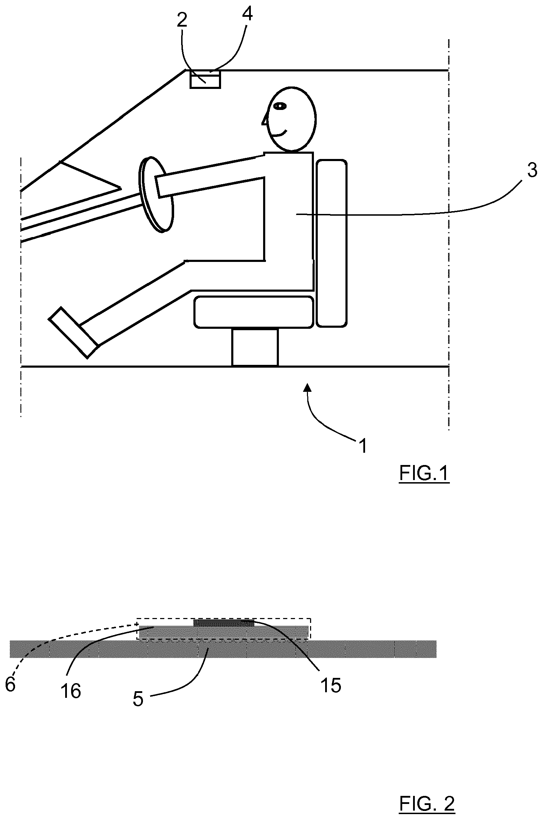

Figure 1 schematically shows a cut-open part of a vehicle 1, where the vehicle 1 comprises a digital camera device 2. The digital camera device 2 is arranged for capturing images of the surroundings outside the vehicle 1. A digital camera device 2 can also, or alternatively, be arranged for capturing images of a driver 3, where these images, which may include eye movements, for example can be used for detecting a degree of driver drowsiness.

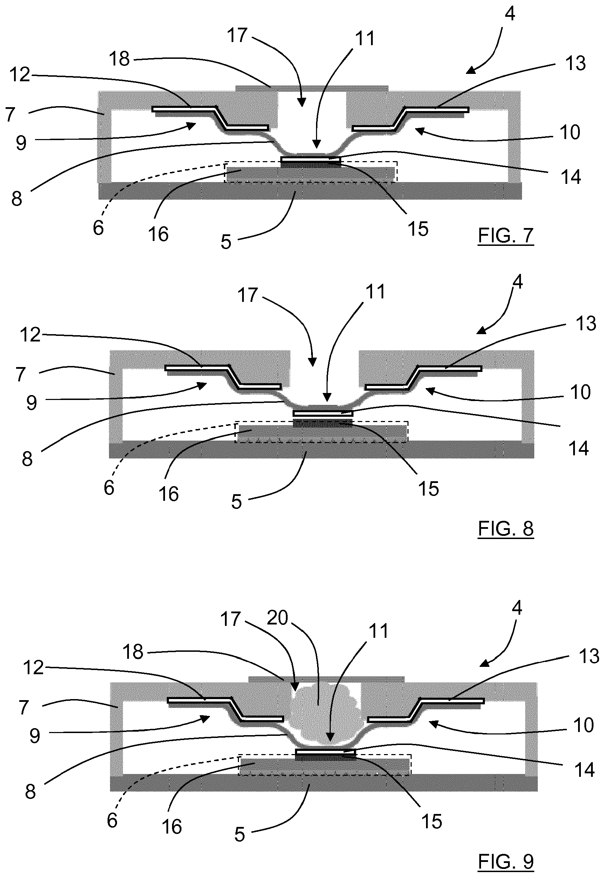

With reference also to Figure 7, the camera device 1 comprises an electronic unit 4 which in turn comprises a PCB 5 (Printed Circuit Board), an electronic component 6 and a metal housing 7 that also serves a heat-sink. In order to transfer heat from the electronic component 6 to the metal housing 7, the electronic unit 4 further comprises a flexible heat transfer element 8 in the form of a foil element 8 that is resiliently attached to the electronic component 6 and the metal housing 7.

The foil element 8 has a first end part 9, a second end part 10 and a central part 11 between the end parts 9, 10, where the end parts 9, 10 are thermally connected to, and attached to, the metal housing 7 via relatively thin corresponding first layers 12, 13 of thermal interface material (TIM). The central part 11 is thermally connected to, and attached to, the electronic component via a relatively thin second layer 14 of TIM. Here, the electronic component 6 comprises a die 15 positioned on a carrier 16, to which die 15 to which the foil element 8 is attached.

According to the present disclosure, in order to enable mounting, the housing comprises an opening 17 enabling the foil element 8 to be thermally connected to the electronic component 6. When the foil element 8 is attached to the housing 7, the opening 17 faces the central part 11. When the housing 7 is mounted to the PCB 5, the opening 17 also faces the electronic component 6, and in particular the die 15. After mounting of the foil element 8 to the electronic component 6, the opening 17 is covered by a cover 18, for example by means of electrically conducting film such as a tape.

Generally, the electronic component 6 can be any kind of heat-generating part or group of two or more heat-generating parts, and is generally constituted by an electronic component arrangement 6. The electronic component arrangement 6 does not necessarily need to be used in a camera device, but can be used in any other type of vehicle equipment, or any other kind of electronic device that need not be adapted for vehicle use.

It has been described that two end parts 9, 10 are thermally connected to, and attached to, the housing 7, and that a central part 11 is thermally connected to, and attached to, the electronic component arrangement 6.

According to some aspects, the foil element 8 can have more or less parts mounted to the housing 7 than the two end parts described, which parts can have any suitable shape and position. The part, or parts, of the foil element 8 that are thermally connected to, and attached to, the housing 7 are generally constituted by first type parts 9, 10.

According to some aspects, the foil element 8 can have more parts mounted to the electronic component arrangement 6 than the central part 11 described, which parts can have any suitable shape and position. The part, or parts, of the foil element 8 that are thermally connected to, and attached to, the electronic component arrangement 6 are generally constituted by second type parts 11. Generally, at least one second type part 11 of the foil element 8 has been pressed towards the electronic component arrangement 6 such that the foil element 8 becomes thermally connected to the electronic component arrangement 6.

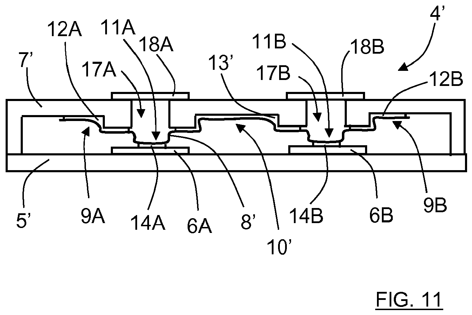

In order to illustrate the above, Figure 11 shows an alternative where, according to some aspects, an electronic unit 4' comprises a PCB 5', a first electronic component arrangement 6A, a second electronic component arrangement 6B and a metal housing 7' that also serves a heat-sink. In order to transfer heat from the electronic component arrangements 6A, 6B to the metal housing 7', the electronic unit 4' further comprises a flexible heat transfer element 8' in the form of a foil element 8' that is resiliently attached to the electronic component arrangements 6A, 6B and the metal housing 7'.

The foil element 8' has first type parts 9A, 9B, 10' that are thermally connected to, and attached to, the metal housing 7' via relatively thin corresponding first layers 12A, 12B, 13' of TIM. Second type parts 11A, 11B of the foil element 8' are thermally connected to, and attached to, the electronic component arrangements 6A, 6B via relatively thin second layers 14A, 14B of TIM.

In accordance with the present disclosure, in order to enable mounting, the housing comprises a first opening 17A and a second opening 17B enabling the foil element 8' to be thermally connected to the electronic component arrangements 6A, 6B. When the foil element 8' is attached to the housing 7', the openings 17A, 17B face the corresponding second type part 11A, 11B. After mounting of the foil element 8' to the electronic component arrangements 6A, 6B, the openings 17A, 17B are covered by corresponding covers 18A, 18B, for example by means of electrically conducting film such as a tape.

It is evident that the present disclosure is applicable for any number of electronic component arrangements and corresponding openings.

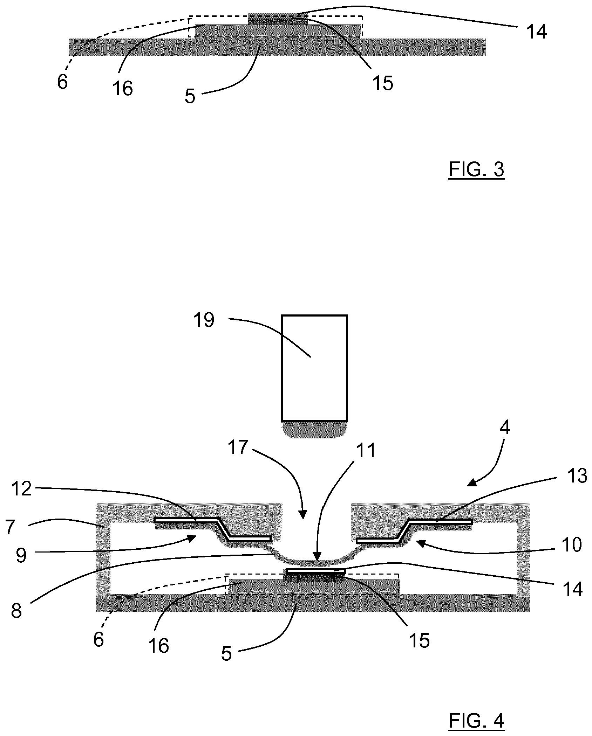

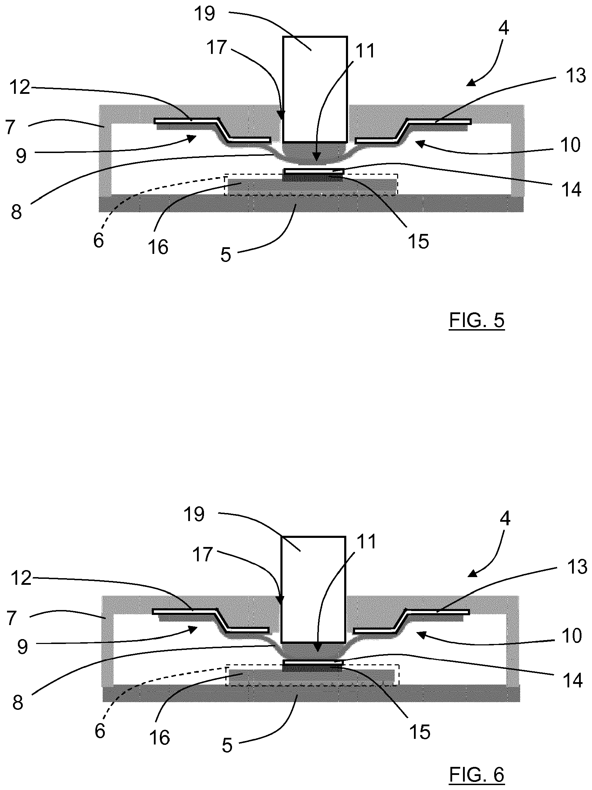

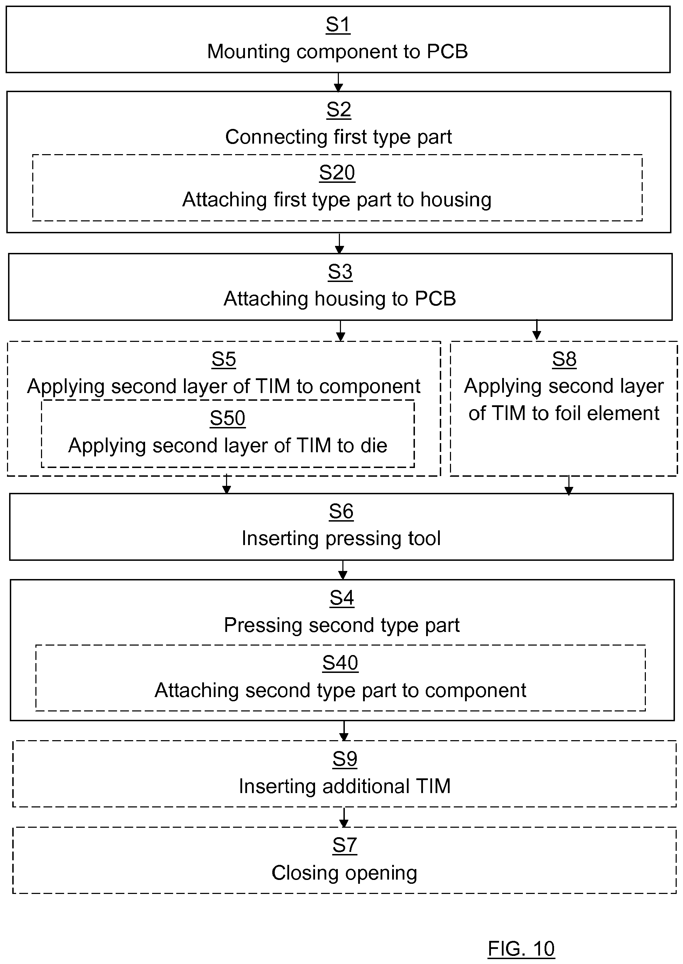

With reference to Figure 2 - Figure 10, the present disclosure also relates to a method for mounting an electronic device 4, where the method comprises mounting S1 an electronic component arrangement 6 to a printed circuit board, PCB 5, thermally connecting S2 at least one first type part 9, 10 of a thermally conducting foil element 8 to a thermally conducting housing 7, and attaching S3 the housing 7 to the PCB 5. The method further comprises, via at least one corresponding opening 17 in the housing 7, pressing S4 at least one second type part 11 of the foil element 8 towards the electronic component arrangement 6 such that the foil element 8 becomes thermally connected to the electronic component arrangement 6.

According to some aspects, each thermal connection is made via a corresponding layer of thermal interface material (TIM) 12, 13, 14.

According to some aspects, the method comprises attaching S20 at least one first type part 9, 10 of the foil element 8 to the housing 7 via a corresponding first layer of TIM 12, 13.

According to some aspects, the method comprises attaching S40 at least one second first type part 11 of the foil element 8 to the electronic component arrangement 6 via a corresponding second layer of TIM 14.

According to some aspects, the method comprises applying S5 said second layer of TIM to the electronic component arrangement 6 before the housing 7 is attached to the PCB 5.

According to some aspects, the method comprises applying S50 said second layer 14 of TIM to a die 15 comprised in the electronic component arrangement 6 before the housing 7 is attached to the PCB 5, and pressing S4 each second type part towards the die via the corresponding opening.

According to some aspects, the method comprises inserting S6 a pressing tool 19 via each opening 17 and using the pressing tool 19 for the pressing S4.

According to some aspects, the method comprises closing S7 the opening 17 by attaching a cover 18 over the opening 17.

According to some aspects, the method comprises inserting S9 at least one additional piece of TIM 20 in at least one opening 17 such that each additional piece 20 of TIM is positioned between the foil element 8 and the corresponding opening 17.

According to some aspects, the cover 18 is an electrically conducting adhesive film.

The present disclosure is not limited to the examples above and the electronic unit described, but may vary freely within the scope of the appended claims. For example, the mounting method according to the present disclosure can be applied to any type of electronic unit, generally in the form of an electronic device that is adapted for the mounting method.

The foil element need not be metallic, but at least thermally conducting. The foil element can alternatively comprise a thermal conductive graphite material that according to some aspects can be covered by a metal film or a protective polymer material.

The housing need not be metallic, but at least thermally conducting. For example, the housing can be made in a thermally conducting material such as a thermally conducting plastic or graphite material that optionally can be covered with an electrically conducting coating.

The TIM can be any kind of suitable thermal interface material such as for example graphite.

Generally, the present disclosure also relates to an electronic device 4 comprising an electronic component arrangement 6 mounted to a printed circuit board 5 (PCB), a thermally conducting housing 7 that is attached to the PCB 5, and a thermally conducting foil element 8 that is thermally connected to the housing 7. The housing 7 comprises an opening 17 enabling the foil element 8 to be thermally connected also to the electronic component arrangement 6.

According to some aspects, the opening 17 is closed by a cover 18 when the foil element 8 has been thermally connected to the electronic component arrangement 6.

According to some aspects, the cover 18 is an electrically conducting adhesive film.

According to some aspects, the housing is formed either in metal or in a thermally conducting non-metallic material.

According to some aspects, the foil element 8 is formed in metal or in a thermally conducting graphite material with a protective coating.

According to some aspects, each thermal connection is made via a corresponding layer of thermal interface material (TIM) 12, 13, 14.

## Claims

1. An electronic device (4) comprising an electronic component arrangement (6) mounted to a printed circuit board (5), PCB, a thermally conducting housing (7) that is attached to the PCB (5), and a thermally conducting foil element (8) that is thermally connected to the housing (7), wherein the housing (7) comprises an opening (17) enabling the foil element (8) to be thermally connected also to the electronic component arrangement (6), where the foil element (8) is positioned between the opening (17) and the electronic component arrangement (6) such that the foil element can be pressed towards the component arrangement (6) via the opening (17), **characterized in that** at least one piece of additional thermal interface material (20), TIM, is positioned between the foil element (8) and the corresponding opening (17).

2. The electronic device (4) according to claim 1, wherein the opening (17) is closed by a cover (18) when the foil element (8) has been thermally connected to the electronic component arrangement (6).

3. The electronic device (4) according to claim 2, wherein the cover (18) is an electrically conducting adhesive film.

4. The electronic device (4) according to any one of the previous claims, wherein the housing is formed in either metal or in a thermally conducting non-metallic material.

5. The electronic device (4) according to any one of the previous claims, wherein the foil element (8) is formed in metal or in a thermally conducting graphite material with a protective coating.

6. The electronic device (4) according to any one of the previous claims, wherein each thermal connection is made via a corresponding layer of thermal interface material (12, 13, 14), TIM.

7. A method for mounting an electronic device (4), where the method comprises:
mounting (S1) an electronic component arrangement (6) to a printed circuit board (5), PCB;
thermally connecting (S2) at least one first type part (9, 10) of a thermally conducting foil element (8) to a thermally conducting housing (7);
attaching (S3) the housing (7) to the PCB (5); and
via at least one corresponding opening (17) in the housing (7), pressing (S4) at least one second type part (11) of the foil element (8) towards the electronic component arrangement (6) such that the foil element (8) becomes thermally connected to the electronic component arrangement (6), **characterized in that** the method comprises inserting (S9) at least one additional piece of thermal interface material (20), TIM, in at least one opening (17) such that each additional piece (20) of TIM is positioned between the foil element (8) and the corresponding opening (17), after the second type part (11) has been pressed (S4).

8. The method according to claim 7, wherein each thermal connection is made via a corresponding layer of thermal interface material (12, 13, 14), TIM.

9. The method according to claim 8, wherein the method comprises attaching (S20) at least one first type part (9, 10) of the foil element (8) to the housing (7) via a corresponding first layer of TIM (12, 13).

10. The method according to any one of the claims 8 or 9, wherein the method comprises attaching (S40) at least one second first type part (11) of the foil element (8) to the electronic component arrangement (6) via a corresponding second layer of TIM (14).

11. The method according to claim 10, wherein the method comprises applying (S5) said second layer of TIM to the electronic component arrangement (6) before the housing (7) is attached to the PCB (5).

12. The method according to one of the claims 10 or 11, wherein the method comprises applying (S50) said second layer (14) of TIM to a die (15) comprised in the electronic component arrangement (6) before the housing (7) is attached to the PCB (5), and pressing (S4) each second type part towards the die via the corresponding opening.

13. The method according to any one of the claims 7-12, wherein the method comprises inserting (S6) a pressing tool (19) via each opening (17) and using the pressing tool (19) for the pressing (S4).

14. The method according to any one of the claims 7-13, wherein the method comprises closing (S7) the opening (17) by attaching a cover (18) over the opening (17).

## Patentansprüche

1. Elektronische Vorrichtung (4), umfassend eine elektronische Bauteilanordnung (6), montiert auf einer Leiterplatte (5), PCB, ein wärmeleitendes Gehäuse (7), das an der PCB (5) befestigt ist, und ein wärmeleitendes Folienelement (8), das thermisch mit dem Gehäuse (7) verbunden ist,
wobei das Gehäuse (7) eine Öffnung (17) umfasst, die dem Folienelement (8) ermöglicht, auch mit der elektronischen Bauteilanordnung (6) thermisch verbunden zu sein, wobei das Folienelement (8) zwischen der Öffnung (17) und der elektronischen Bauteilanordnung (6) positioniert ist, sodass das Folienelement über die Öffnung (17) in Richtung der Bauteilanordnung (6) gepresst werden kann, **dadurch gekennzeichnet, dass** zumindest ein Stück von zusätzlichem thermischem Zwischenlagematerial (20), TIM, zwischen dem Folienelement (8) und der entsprechenden Öffnung (17) positioniert ist.

2. Elektronische Vorrichtung (4) nach Anspruch 1, wobei die Öffnung (17) durch eine Abdeckung (18) geschlossen ist, wenn das Folienelement (8) thermisch mit der elektronischen Bauteilanordnung (6) verbunden wurde.

3. Elektronische Vorrichtung (4) nach Anspruch 2, wobei die Abdeckung (18) ein elektrisch leitfähiger Klebstofffilm ist.

4. Elektronische Vorrichtung (4) nach einem der vorhergehenden Ansprüche, wobei das Gehäuse entweder aus Metall oder aus einem wärmeleitenden nicht-metallischen Material gebildet ist.

5. Elektronische Vorrichtung (4) nach einem der vorhergehenden Ansprüche, wobei das Folienelement (8) aus Metall oder aus einem wärmeleitenden Graphitmaterial mit einer Schutzbeschichtung gebildet ist.

6. Elektronische Vorrichtung (4) nach einem der vorhergehenden Ansprüche, wobei jede thermische Verbindung über eine entsprechende Schicht von thermischem Zwischenlagematerial (12, 13, 14), TIM, erfolgt.

7. Verfahren zum Montieren einer elektronischen Vorrichtung (4), wobei das Verfahren Folgendes umfasst:
Montieren (S1) einer elektronischen Bauteilanordnung (6) auf einer Leiterplatte (5), PCB;
thermisches Verbinden (S2) zumindest eines Teils eines ersten Typs (9, 10) eines wärmeleitenden Folienelements (8) mit einem wärmeleitenden Gehäuse (7);
Befestigen (S3) des Gehäuses (7) an der PCB (5); und über zumindest eine entsprechende Öffnung (17) im Gehäuse (7), Pressen (S4) zumindest eines Teils von einem zweiten Typ (11) des Folienelements (8) in Richtung der elektronischen Bauteilanordnung (6), sodass das Folienelement (8) thermisch mit der elektronischen Bauteilanordnung (6) verbunden wird, **dadurch gekennzeichnet, dass** das Verfahren Folgendes umfasst: Einsetzen (S9) zumindest eines zusätzlichen Stückes von thermischem Zwischenlagematerial (20), TIM, in zumindest eine Öffnung (17), sodass jedes zusätzliche Stück (20) von TIM zwischen dem Folienelement (8) und der entsprechenden Öffnung (17) positioniert ist, nachdem das Teil vom zweiten Typ (11) gepresst wurde (S4).

8. Verfahren nach Anspruch 7, wobei jede thermische Verbindung über eine entsprechende Schicht von thermischem Zwischenlagematerial (12, 13, 14), TIM, erfolgt.

9. Verfahren nach Anspruch 8, wobei das Verfahren Folgendes umfasst: Befestigen (S20) zumindest eines Teils vom ersten Typ (9, 10) des Folienelements (8) am Gehäuse (7) über eine entsprechende erste Schicht von TIM (12, 13) .

10. Verfahren nach einem der Ansprüche 8 oder 9, wobei das Verfahren Folgendes umfasst: Befestigen (S40) zumindest eines Teils vom zweiten Typ (11) des Folienelements (8) an der elektronischen Bauteilanordnung (6) über eine entsprechende zweite Schicht von TIM (14).

11. Verfahren nach Anspruch 10, wobei das Verfahren Folgendes umfasst: Auftragen (S5) der zweiten Schicht von TIM auf die elektronische Bauteilanordnung (6), bevor das Gehäuse (7) an der PCB (5) befestigt wird.

12. Verfahren nach einem der Ansprüche 10 oder 11, wobei das Verfahren Folgendes umfasst: Auftragen (S50) der zweiten Schicht (14) von TIM auf einen Die (15), der in der elektronischen Bauteilanordnung (6) enthalten ist, bevor das Gehäuse (7) an der PCB (5) befestigt wird, und Pressen (S4) jedes Teils vom zweiten Typ in Richtung des Dies über die entsprechende Öffnung.

13. Verfahren nach einem der Ansprüche 7-12, wobei das Verfahren Folgendes umfasst: Einsetzen (S6) eines Presswerkzeugs (19) über jede Öffnung (17) und Verwenden des Presswerkzeugs (19) für das Pressen (S4).

14. Verfahren nach einem der Ansprüche 7-13, wobei das Verfahren Folgendes umfasst: Schließen (S7) der Öffnung (17) durch Befestigen einer Abdeckung (18) über der Öffnung (17).

## Revendications

1. Dispositif électronique (4) comprenant un agencement de composants électroniques (6) monté sur une carte de circuit imprimé (5), PCB, un boîtier conducteur thermiquement (7) qui est fixé à la PCB (5), et un élément feuille conducteur thermiquement (8) qui est connecté thermiquement au boîtier (7), le boîtier (7) comprenant une ouverture (17) permettant à l'élément feuille (8) d'être aussi connecté thermiquement à l'agencement de composants électroniques (6), l'élément feuille (8) étant positionné entre l'ouverture (17) et l'agencement de composants électroniques (6) de telle sorte que l'élément feuille peut être pressé vers l'agencement de composants (6) via l'ouverture (17), **caractérisé en ce qu'**au moins une pièce de matériau d'interface thermique (20), TIM, additionnel est positionnée entre l'élément feuille (8) et l'ouverture correspondante (17).

2. Dispositif électronique (4) selon la revendication 1, l'ouverture (17) étant fermée par un couvercle (18) lorsque l'élément feuille (8) a été connecté thermiquement à l'agencement de composants électroniques (6) .

3. Dispositif électronique (4) selon la revendication 2, le couvercle (18) étant un film adhésif conducteur électriquement.

4. Dispositif électronique (4) selon l'une quelconque des revendications précédentes, le boîtier étant formé dans soit du métal soit un matériau non métallique conducteur thermiquement.

5. Dispositif électronique (4) selon l'une quelconque des revendications précédentes, l'élément feuille (8) étant formé dans du métal ou dans un matériau graphite conducteur thermiquement avec une couche protectrice.

6. Dispositif électronique (4) selon l'une quelconque des revendications précédentes, chaque connexion thermique étant faite via une couche correspondante de matériau d'interface thermique (12, 13, 14), TIM.

7. Procédé de montage d'un dispositif électronique (4), où le procédé comprend :
le montage (S1) d'un agencement de composants électroniques (6) sur une carte de circuit imprimé (5), PCB ;
la connexion thermique (S2) d'au moins une partie de premier type (9, 10) d'un élément feuille conducteur thermiquement (8) à un boîtier conducteur thermiquement (7) ;
l'attache (S3) du boîtier (7) à la PCB (5) ; et
via au moins une ouverture (17) correspondante dans le boîtier (7), le pressage (S4) d'au moins une partie de deuxième type (11) de l'élément feuille (8) vers l'agencement de composants électroniques (6) de telle sorte que l'élément feuille (8) devient connecté thermiquement à l'agencement de composants électroniques (6), **caractérisé en ce que** le procédé comprend l'insertion (S9) d'au moins une pièce additionnelle de matériau d'interface thermique (20), TIM, dans au moins une ouverture (17) de telle sorte que chaque pièce additionnelle (20) de TIM est positionnée entre l'élément feuille (8) et l'ouverture (17) correspondante, après que la partie de deuxième type (11) a été pressée (S4).

8. Procédé selon la revendication 7, chaque connexion thermique étant faite via une couche correspondante de matériau d'interface thermique (12, 13, 14), TIM.

9. Procédé selon la revendication 8, le procédé comprenant la fixation (S20) d'au moins une partie de premier type (9, 10) de l'élément feuille (8) au boîtier (7) via une première couche correspondante de TIM (12, 13) .

10. Procédé selon l'une quelconque des revendications 8 ou 9, le procédé comprenant la fixation (S40) d'au moins une partie de deuxième type (11) de l'élément feuille (8) à l'agencement de composants électroniques (6) via une deuxième couche correspondante de TIM (14).

11. Procédé selon la revendication 10, le procédé comprenant l'application (S5) de ladite deuxième couche de TIM sur l'agencement de composants électroniques (6) avant que le boîtier (7) ne soit fixé à la PCB (5).

12. Procédé selon l'une des revendications 10 ou 11, le procédé comprenant l'application (S50) de ladite deuxième couche de TIM (14) sur une puce (15) comprise dans l'agencement de composants électroniques (6) avant que le boîtier (7) ne soit fixé à la PCB (5), et le pressage (S4) de chaque partie de deuxième type vers la puce via l'ouverture correspondante.

13. Procédé selon l'une quelconque des revendications 7 à 12, le procédé comprenant l'insertion (S6) d'un outil de pressage (19) via chaque ouverture (17) et l'utilisation de l'outil de pressage (19) pour le pressage (S4).

14. Procédé selon l'une quelconque des revendications 7 à 13, le procédé comprenant la fermeture (S7) de l'ouverture (17) en fixant un couvercle (18) par-dessus l'ouverture (17).
